# DEMANDE DE BREVET EUROPEEN

(11) **EP 1 429 458 A2**
(43) Date de publication de la demande: **16.06.2004**
(21) Numéro de dépôt: 03300267.6
(22) Date de dépôt: 12.12.2003
(51) Int. Cl.: H03H 7/42

(54) **Transformateur à changement de mode sélectif en fréquences**

(30) Priorité: 13.12.2002 FR 0215836
(71) Demandeur: STMicroelectronics S.A., 92120 Montrouge (FR)
(72) Inventeur: Guitton, Fabrice, 37100 Tours (FR); Dupont, François, 37000 Tours (FR)
(74) Mandataire: de Beaumont, Michel

(57) **Abrégé**

L'invention concerne un transformateur (30) à changement de mode sélectif sur une bande centrée sur une première fréquence comprenant, entre une même borne d'entrée/sortie (5) de mode commun et respectivement une de deux bornes d'entrée/sortie (3, 4) de mode différentiel, un filtre passe-haut (34) de fréquence de coupure inférieure à ladite première fréquence, un filtre passe-bande (33) de fréquence centrale supérieure à ladite première fréquence.

## Description

La présente invention concerne le domaine des transformateurs à changement de mode qui sont utilisés pour convertir une tension de mode commun en mode différentiel et inversement. De tels transformateurs sont généralement appelés "BALUN", de l'anglais "balanced-unbalanced".

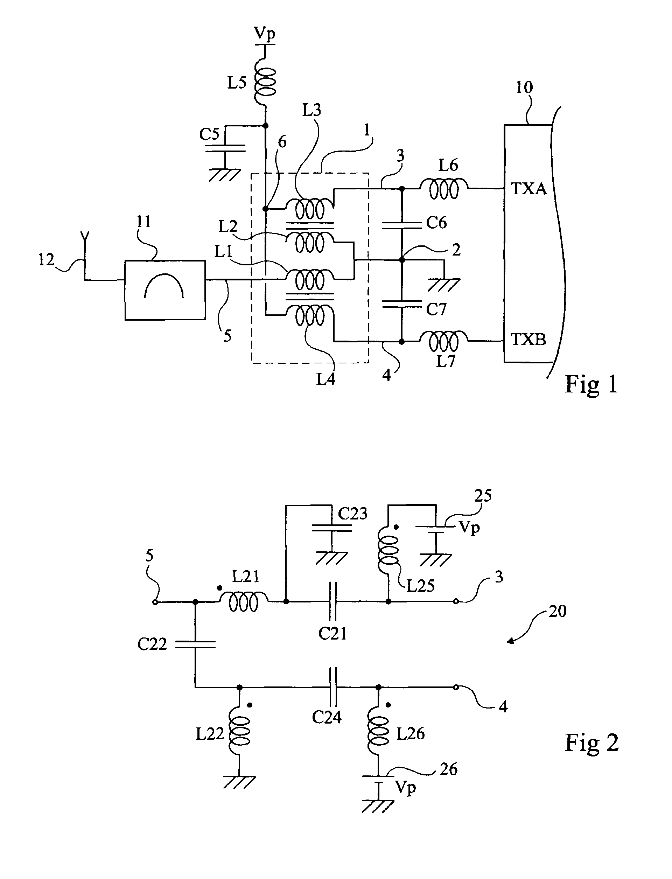

La figure 1 illustre, de façon très schématique, un exemple de transformateur à changement de mode 1 dans un environnement applicatif. Il s'agit, par exemple, d'une chaîne d'émission de téléphone portable. Ce genre d'application a couramment recours à des dispositifs de type BALUN dans la mesure où, côté antenne, il s'agit le plus souvent d'un dispositif à une seule extrémité.

Le transformateur 1 est essentiellement constitué d'enroulements inductifs couplés. Un premier enroulement est constitué de deux tronçons L1 et L2 en série et de mêmes valeurs dont le point milieu 2 constitue le point milieu (généralement la masse) des entrées/sorties 3 et 4 de mode différentiel du transformateur. Une première extrémité de l'enroulement L2 constitue la borne d'entrée/sortie 5 de mode commun tandis que l'autre extrémité est en l'air. Un deuxième enroulement est constitué de deux tronçons L3 et L4 de mêmes valeurs en série et dont les bornes d'extrémité définissent les bornes 3 et 4 d'entrée/sortie côté mode différentiel. Les tronçons L1 et L2 sont respectivement couplés aux tronçons L3 et L4. Le point milieu 6 de l'association en série des tronçons L3 et L4 reçoit une tension de polarisation Vp (composante continue) du transformateur par l'intermédiaire d'une inductance L5, un condensateur C5 reliant la borne 6 à la masse 2. Chaque borne 3 et 4 est reliée à une borne TXA et TXB d'un circuit 10 d'émission/réception radiofréquences par une inductance respective L6 ou L7. En outre, les bornes 3 et 4 sont respectivement reliées à la borne 2 par des condensateurs C6 et C7. Les inductances L6, L7 et les condensateurs C6, C7 constituent un circuit d'adaptation d'impédance entre l'impédance différentielle du BALUN et l'impédance d'entrée du circuit 10.

Pour rendre un tel transformateur de changement de mode sélectif, un filtre 11 relie la borne 5 d'entrée/sortie côté mode commun à l'antenne 12 d'émission-réception. Le filtre 11 est un filtre passe-bande qui, notamment dans les applications d'émission-réception radiofréquences de type téléphonie mobile, doit être sélectif.

Pour gagner de la place, on a déjà proposé de réaliser un transformateur à changement de mode de type BALUN au moyen de deux filtres respectivement passe-bas et passe-haut réalisés à partir d'éléments capacitifs et inductifs.

La figure 2 représente le schéma électrique d'un tel transformateur classique 20. On y retrouve une borne 5 d'entrée/sortie de mode commun et deux bornes 3 et 4 d'entrée/sortie de mode différentiel.

Le transformateur proprement dit est constitué de deux inductances L21 et L22 et de quatre condensateurs C21 à C24. L'inductance L21 est en série avec le condensateur C21 entre les bornes 5 et 3, le point milieu de cette association en série étant relié à la masse par l'intermédiaire du condensateur C23. Le condensateur C22 est en série avec le condensateur C24 entre les bornes 5 et 4, le point milieu de cette association en série étant relié à la masse par l'inductance L22.

La fixation de la composante continue du signal différentiel est fournie sur chacune des bornes 3 et 4 par des sources de tension Vp, respectivement 25 et 26. Deux inductances L25 et L26 relient les électrodes positives des sources 25 et 26 aux bornes 3 et 4 respectivement. Le rôle des inductances L25 et L26 est de servir de bouchon afin d'éviter que le signal dynamique traversant le transformateur à changement de mode n'atteigne les alimentations. Les condensateurs C21 et C24 empêchent que la composante continue atteigne la borne 5.

La branche constituée de l'inductance L21 et du condensateur C23 forme un filtre passe-bas tandis que la branche constituée du condensateur C22 et de l'inductance L22 forme un filtre passe-haut. Les filtres sont dimensionnés pour avoir une même fréquence de coupure (fréquence où l'atténuation correspond à -3 dB). Par ailleurs, chaque filtre apporte un déphasage de 90° au signal de mode commun appliqué sur la borne 5 avec toutefois un signe inversé selon la borne 3 ou 4 de sortie. Par conséquent, on obtient bien, à la fréquence de coupure, un déphasage de 180° entre les bornes 3 et 4.

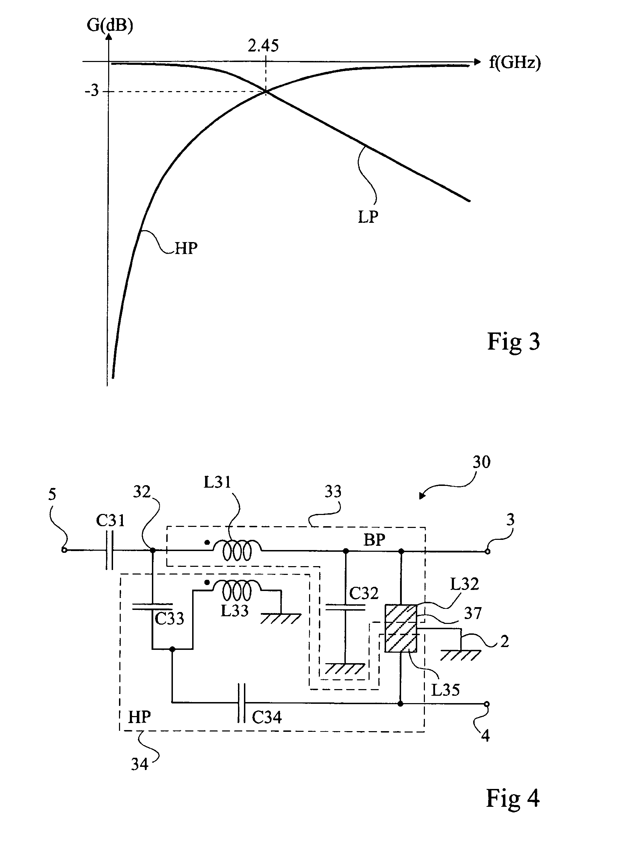

La figure 3 illustre la réponse en fréquence du gain G du transformateur de changement de mode de la figure 2 en fonction de la fréquence f. Dans cet exemple, les deux courbes LP et HP, correspondant respectivement aux réponses en fréquence des filtres passe-bas et passe-haut, se croisent à une fréquence de 2,45 GHz pour laquelle l'atténuation est de -3 dB. Cette fréquence correspond donc à la fréquence centrale du transformateur de changement de mode.

C'est le déséquilibre entre les deux entrées/sorties du mode différentiel dès que l'on s'écarte de la fréquence de 2,45 Gigahertz qui limite la plage d'utilisation d'un tel BALUN. Ce déséquilibre est lié au fait que le déphasage de plus et moins 90° n'est maintenu que sur une bande limitée mais adaptée à la plupart des applications.

Un autre inconvénient est que deux inductances L21 et L22 sont nécessaires pour réaliser les filtres. De plus, deux inductances supplémentaires L25 et L26 sont nécessaires pour apporter la polarisation.

La présente invention vise à proposer un transformateur à changement de mode sélectif en fréquences, qui pallie les inconvénients des transformateurs connus. En particulier, l'invention vise à proposer un transformateur qui applique un filtrage du mode commun vers le mode différentiel, dans la bande passante duquel le déphasage entre les entrées/sorties du mode différentiel est sensiblement constant, et dont l'encombrement est minimisé.

L'invention vise également à proposer une structure de transformateur compatible avec l'adjonction d'une composante continue côté mode différentiel.

Pour atteindre ces objets et d'autres, la présente invention prévoit un transformateur à changement de mode sélectif sur une bande centrée sur une première fréquence, comprenant, entre une même borne d'entrée/sortie de mode commun et respectivement une de deux bornes d'entrée/sortie de mode différentiel, un filtre passe-haut de fréquence de coupure inférieure à ladite première fréquence ; et un filtre passe-bande de fréquence centrale supérieure à ladite première fréquence.

Selon un mode de réalisation de la présente invention, les deux filtres sont liés par un couplage inductif.

Selon un mode de réalisation de la présente invention, le filtre passe-haut est du deuxième ordre.

Selon un mode de réalisation de la présente invention, la fréquence centrale du filtre passe-bande est inférieure à 1,5 fois ladite première fréquence.

Selon un mode de réalisation de la présente invention, la fréquence de coupure du filtre passe-haut est supérieure à 0,5 fois la première fréquence.

Selon un mode de réalisation de la présente invention, le filtre passe-bande comprend, entre une borne d'entrée du filtre et une desdites bornes d'entrée/sortie de mode différentiel, une première inductance, une deuxième inductance étant en parallèle avec un premier condensateur entre ladite borne d'entrée/sortie et la masse.

Selon un mode de réalisation de la présente invention, le filtre passe-haut comporte un premier condensateur dont une première électrode est reliée à une borne d'entrée du filtre et dont une deuxième électrode est connectée, par une première inductance, à la masse ; et un deuxième condensateur dont une première électrode est connectée au point milieu de l'association en série du premier condensateur et de la première inductance et dont une deuxième électrode est connectée à une desdites bornes d'entrée/sortie de mode différentiel et, par une deuxième inductance, à la masse.

Selon un mode de réalisation de la présente invention, les premières inductances des filtres passe-bande et passe-haut sont couplées entre elles et ont une même valeur.

Selon un mode de réalisation de la présente invention, les deuxièmes inductances des filtres passe-bande et passe-haut sont réalisées par une ligne de transmission dont la valeur conditionne la fréquence centrale du filtre passe-bande.

Selon un mode de réalisation de la présente invention, la valeur de la deuxième inductance du filtre passe-haut est fonction de la fréquence de coupure attendue pour ce filtre.

Selon un mode de réalisation de la présente invention, la borne d'entrée des filtres est commune.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente, de façon très schématique, un exemple d'application d'un transformateur à changement de mode connu ;
la figure 2 décrite précédemment représente un exemple classique de transformateur à changement de mode ;
la figure 3 décrite précédemment illustre la réponse en fréquence du transformateur de la figure 2 ;
la figure 4 représente un mode de réalisation d'un transformateur à changement de mode selon la présente invention ;
la figure 5 illustre le schéma électrique du transformateur de la figure 4 en statique ;
la figure 6 illustre le schéma électrique du transformateur de la figure 4 en dynamique ; et
la figure 7 illustre la réponse en fréquence du transformateur à changement de mode décrit en relation avec les figures 4 et 6.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, la destination des signaux côté mode commun et côté différentiel n'a pas été détaillée. De plus, si l'invention s'applique plus particulièrement à des transformateurs à changement de mode de transmission radiofréquences, il s'agit là d'un exemple d'application non limitatif.

Une caractéristique de la présente invention est d'associer un filtre passe-haut et un filtre passe-bande pour réaliser un transformateur à changement de mode sélectif en fréquences. Une autre caractéristique de l'invention est de prévoir un filtre passe-haut du deuxième ordre de façon à obtenir un déphasage de 180° alors que le filtre passe-bande a un déphasage nul à la fréquence de résonance.

De plus, pour des raisons d'encombrement, les deux filtres peuvent être couplés au moyen d'une inductance comme on le verra par la suite.

La figure 4 représente un transformateur à changement de mode 30 selon un mode de réalisation de la présente invention. Pour simplifier, la figure 4 ne tient pas compte des éventuelles polarisations de composante continue.

Chaque borne 3 ou 4 d'entrée/sortie de mode différentiel est associée à un des filtres parmi le filtre passe-haut 34 (HP) et le filtre passe-bande 33 (BP). Dans l'exemple représenté, et arbitrairement, la borne 3 est associée au filtre passe-bande tandis que la borne 4 est associée au filtre passe-haut. Côté borne 5 d'entrée/sortie de mode commun, un condensateur C31 relie la borne 5 à une borne 32 d'entrée commune des deux filtres.

Le filtre passe-bande 33 comporte une inductance L31 dont une borne est connectée à la borne 32 et dont l'autre borne est connectée directement à la borne 3. Un condensateur C32 relie la borne 3 à la masse 2 du mode différentiel. Une ligne de transmission ou inductance 37, constituée pour la partie filtre passe-bas 33 d'une inductance L32 comme on le verra par la suite, relie la borne 3 à la masse 2.

Le filtre passe-haut 34 est un filtre du deuxième ordre. Il comprend un condensateur C33 dont une première électrode est connectée à la borne 32 et dont une deuxième électrode est connectée, par l'intermédiaire d'un condensateur C34, à la borne 4 et, par l'intermédiaire d'une inductance L33, à la masse 2. La borne 4 est par ailleurs connectée par la ligne de transmission L34 à la borne 3, ce qui revient à dire qu'une inductance L35 relie la borne 4 à la borne 2.

Selon un mode de réalisation préféré de l'invention, les inductances L31 et L33 sont couplées. Le facteur de couplage est, par exemple, compris entre 0 et ±1, de préférence de -0,7.

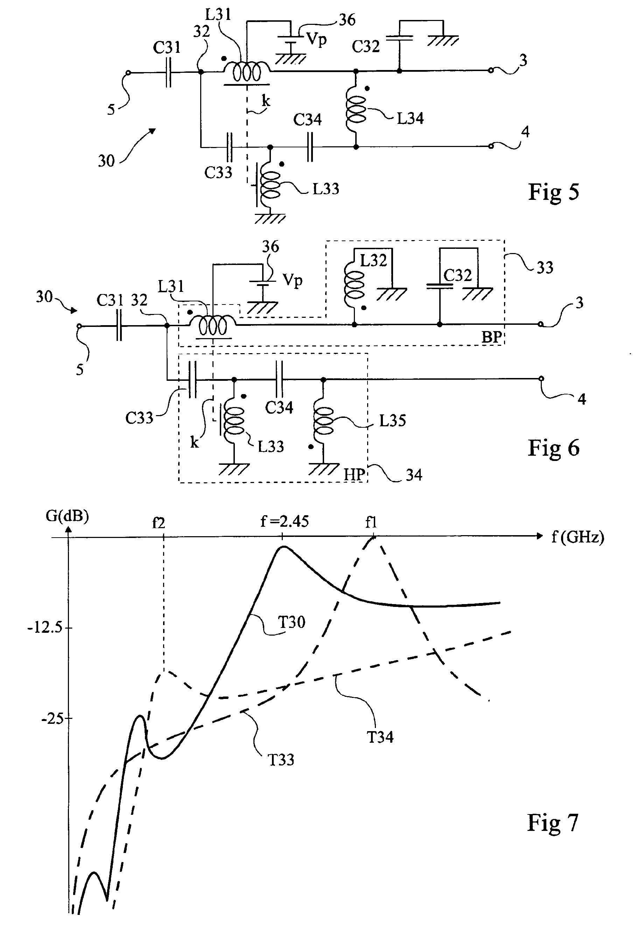

La figure 5 représente le schéma électrique du transformateur à changement de mode 30 de la figure 4 en prévoyant une alimentation de polarisation fixant une composante continue Vp au moyen d'une source 36. Dans la représentation de la figure 5, le couplage k entre les inductances L31 et L33 a été représenté par un pointillé les reliant. On retrouve autrement les mêmes constituants qu'en figure 4 à la différence près que la ligne de transmission ou inductance 37 a été représentée sous la forme d'une inductance L34 (L34 = L32 + L35) reliant les bornes 3 et 4.

La représentation de la figure 5 permet d'illustrer le chemin de la composante continue Vp jusqu'aux bornes 3 et 4. Dans ce mode de réalisation, l'électrode positive de la source 36 est reliée à un point milieu de l'inductance L31. Dans ce cas, le courant circule jusqu'à la borne 3 depuis la source 36 à partir de son électrode positive à travers la demi inductance L31. Pour la borne 4, le courant circule à travers la demi-inductance L31 et à travers l'inductance L34 pour atteindre la borne 4. Le condensateur C31 évite que la composante continue de polarisation atteigne la borne 5.

La figure 6 représente le schéma du transformateur à changement de mode 30 des figures 4 et 5 dans une troisième représentation faisant ressortir le fonctionnement en dynamique. Le couplage k entre les inductances L31 et L33 est encore représenté par un pointillé. Par contre, l'inductance L34 a été dissociée en deux inductances L32 et L35 reliant respectivement les bornes 3 et 4 à la masse 2.

La valeur de l'inductance L32 contribue à fixer la fréquence centrale du filtre passe-bande. La valeur de l'inductance L33 fixe le premier ordre du filtre passe-haut 34 tandis que l'inductance L35 fixe son deuxième ordre. La ligne L34 conditionne donc la fréquence centrale du filtre 33 et le deuxième ordre du filtre 34.

L'inductance L31 n'intervient pas sur la réponse du filtre passe-bande sauf pour décaler sa fréquence centrale en direction de la fréquence centrale du filtre passe-haut. Par ailleurs, l'inductance L31 sert d'isolation sur la ligne du filtre passe-bande.

La figure 7 illustre la réponse en fréquence du transformateur à changement de mode selon l'invention. Les réponses respectives des filtres passe-bande et passe-haut considérées de manière séparée figurent sous forme de traits mixtes T33 et de pointillés T34. La réponse globale est illustrée en trait plein T30. Comme l'illustre la figure 7, la fréquence centrale f du transformateur à changement de mode (dans cet exemple, 2,45 GHz) est comprise entre la fréquence de coupure f2 du filtre passe-haut et la fréquence centrale f1 du filtre passe-bande. L'écart entre les fréquences f1 et f2 dépend de la phase de chaque filtre ainsi que du couplage k.

Pour garantir un couplage correct, la fréquence centrale f1 du filtre passe-bande est de préférence inférieure à 1,5 fois la fréquence centrale f du transformateur à changement de mode souhaité. La fréquence de coupure f2 du filtre passe-haut est de préférence supérieure à 0,5 fois la fréquence centrale f du transformateur à changement de mode souhaité.

Les fréquences f1 et f2 respectives des filtres sont déterminées d'après la formule 1/2π√LC pour la fréquence f1 et pour la fréquence de coupure du premier étage du filtre passe-haut, la fréquence de coupure du deuxième étage étant imposée (car un élément est en commun avec le filtre passe-bande).

L'inductance L31 permet de minimiser la différence d'amplitudes entre les deux trajets jusqu'aux bornes 4 et 5. En son absence, cet équilibre en amplitude est difficile dans la mesure où le trajet du filtre passe-bande présente une atténuation toujours plus faible que le trajet du filtre passe-haut (voir la figure 6).

Par ailleurs, dans une réalisation intégrée, le couplage réduit la taille du transformateur à changement de mode dans la mesure où il permet de superposer les deux inductances L31 et L33 réalisées sous la forme de pistes conductrices (dans deux niveaux de métallisation séparés par un diélectrique).

Pour la mise en oeuvre de l'invention, on pourra suivre, par exemple, les étapes de dimensionnement suivantes.

On commence par concevoir un filtre passe-bande de fréquence f1 légèrement supérieure à la fréquence f visée. Puis un filtre passe-haut de fréquence f2 légèrement inférieure à la fréquence f visée, et on fait en sorte que les impédances d'entrée des deux filtres soient complexes conjuguées et que leur mise en parallèle équivale à une impédance adaptée (par exemple, 50 ohms réels).

On adapte enfin, par exemple au moyen d'outils numériques de simulation, les composants pour ajuster les performances notamment en terme de couplage des amplitudes, de pertes d'insertion, et d'équilibre des voies différentielles en amplitude et phase.

A titre d'exemple particulier de réalisation, pour un transformateur à changement de mode centré sur une fréquence de l'ordre de 2,45 GHz, on pourra dimensionner les composants de la façon suivante :
L31 = 3,82 nanohenrys ;
L33 = 3,82 nanohenrys ;
k entre 31 et 33 = -0,7 ;
C31 = 31,7 picofarads ;
C33 = 20,1 picofarads ;
C32 = 6,32 picofarads ; et
L34 = 0,79 nanohenry.

Dans une telle réalisation, on voit que la valeur de l'inductance L34 est compatible avec sa réalisation sous la forme d'une ligne de transmission. Par conséquent, une seule inductance L31 et L32 couplée et quatre condensateurs suffisent à la réalisation du transformateur à changement de mode. La surface dans une réalisation intégrée est donc particulièrement réduite.

Un avantage de la présente invention est qu'elle permet la réalisation d'un transformateur à changement de mode sélectif en fréquence, de faible encombrement et particulièrement performant.

Un autre avantage de l'invention est qu'elle permet de respecter le déphasage de 180° et une amplitude identique entre les deux voies différentielles dans toute la bande passante du transformateur.

Un autre avantage de la présente invention est que la polarisation ne requiert pas deux éléments inductifs supplémentaires.

Bien entendu, la présente invention est susceptible de diverses variantes et modifications qui apparaîtront à l'homme de l'art. En particulier, les dimensionnements des filtres en fonction de l'application et notamment de la fréquence souhaitée seront à adapter au cas d'espèce et les outils de simulation aujourd'hui disponibles permettront à l'homme du métier d'optimiser la structure.

## Revendications

1. Transformateur (30) à changement de mode sélectif sur une bande centrée sur une première fréquence (f), **caractérisé en ce qu'**il comprend, entre une même borne d'entrée/sortie (5) de mode commun et respectivement une de deux bornes d'entrée/sortie (3, 4) de mode différentiel :
un filtre passe-haut (34) de fréquence de coupure (f2) inférieure à ladite première fréquence ; et
un filtre passe-bande (33) de fréquence centrale (f1) supérieure à ladite première fréquence.

2. Transformateur selon la revendication 1, dans lequel les deux filtres (33, 34) sont liés par un couplage inductif (L31, L33).

3. Transformateur selon la revendication 1 dans lequel le filtre passe-haut (34) est du deuxième ordre.

4. Transformateur selon la revendication 1, dans lequel la fréquence centrale (f1) du filtre passe-bande (33) est inférieure à 1,5 fois ladite première fréquence (f).

5. Transformateur selon la revendication 1, dans lequel la fréquence de coupure (f2) du filtre passe-haut (34) est supérieure à 0,5 fois la première fréquence (f).

6. Transformateur selon la revendication 1, dans lequel le filtre passe-bande (33) comprend, entre une borne (32) d'entrée du filtre et une desdites bornes d'entrée/sortie (3, 4) de mode différentiel, une première inductance (L31), une deuxième inductance (L32) étant en parallèle avec un premier condensateur (C32) entre ladite borne d'entrée/sortie (3) et la masse (2).

7. Transformateur selon la revendication 1, dans lequel le filtre passe-haut (34) comporte :
un premier condensateur (C33) dont une première électrode est reliée à une borne d'entrée (32) du filtre et dont une deuxième électrode est connectée, par une première inductance (L33), à la masse (2) ; et
un deuxième condensateur (C34) dont une première électrode est connectée au point milieu de l'association en série du premier condensateur et de la première inductance et dont une deuxième électrode est connectée à une (4) desdites bornes (3, 4) d'entrée/sortie de mode différentiel et, par une deuxième inductance (L35), à la masse.

8. Transformateur selon les revendications 6 et 7, dans lequel les premières inductances (L31, L33) des filtres passe-bande (33) et passe-haut (34) sont couplées entre elles et ont une même valeur.

9. Transformateur selon les revendications 5 et 6, dans lequel les deuxièmes inductances (L32, L35) des filtres passe-bande (33) et passe-haut (34) sont réalisées par une ligne de transmission (L34) dont la valeur conditionne la fréquence centrale (f1) du filtre passe-bande.

10. Transformateur selon la revendication 9, dans lequel la valeur de la deuxième inductance (L35) du filtre passe-haut (34) est fonction de la fréquence de coupure (f2) attendue pour ce filtre.

11. Transformateur selon les revendications 8 et 9, dans lequel la borne d'entrée (32) des filtres (33, 34) est commune.
